# EUROPEAN PATENT SPECIFICATION

(11) **EP 3 635 860 B1**
(45) Date of publication and mention of the grant of the patent: **17.03.2021**
(21) Application number: 18717738.1
(22) Date of filing: 06.04.2018
(51) Int. Cl.: H02S 40/42

(54) **HEAT SINK PANEL FOR A PHOTOVOLTAIC PANEL**
KÜHLKÖRPERPLATTE FÜR FOTOVOLTAISCHES PANEEL
PANNEAU DISSIPATEUR DE CHALEUR DESTINÉ À UN PANNEAU PHOTOVOLTAÏQUE

(30) Priority: 09.06.2017 NL 2019040
(43) Date of publication of application: 15.04.2020
(73) Proprietor: Optixolar Holding B.V., 9636 HT Zuidbroek (NL)
(72) Inventor: HUTTING, Hendrik Kornelis, 9636 HT Zuidbroek (NL); MEIJER, Simon Daniel, 9636 HT Zuidbroek (NL)
(74) Representative: V.O.
(86) International application number: PCT/NL2018/050213
(87) International publication number: WO 2018/226091

(56) References cited:
- DE-A1- 3 611 543
- FR-A1- 2 923 082
- US-A1- 2005 161 074

## Description

### TECHNICAL FIELD

The various aspects and embodiments thereof relate to the field of heat sinks for photovoltaic panels.

### BACKGROUND

As photovoltaic panels - solar panels - are placed in sunlight as much and as long as possible and because they are arranged to reflect as little sunlight as possible, they heat up. And because these panels usually comprise an active layer comprising semiconductor material, the heat affects the efficiency of the photovoltaic panel in a negative way.

Various cooling efforts are known, including liquid cooling and placement of heat sinks. Use of passive cooling is preferred, as photovoltaic panels are usually placed at remote and/or difficult to reach places. Therefore, a low-maintenance / low cost cooling application is preferred.

US 2005/0161074 discloses a substrate for a photovoltaic unit that comprises a plurality of ridges and one or more troughs where the substrate is where the substrate is connected to the bottom side of a photovoltaic module.

DE3611543 discloses a photovoltaic module and a supporting plate at the back of the photovoltaic module. The plate comprises a layer of corrugated aluminium or steel.

FR2923082 discloses a photovoltaic panel comprising a metallic panel providing a support surface and at least one photovoltaic cell fixed on the support surface. In the metallic, directly below the photovoltaic cells, openings are provided for accommodating electrical connectors for the photovoltaic cells; the photovoltaic cells seal off the openings. Ridges are provided in the metallic panel between the photovoltaic cells in order to let air flow through for cooling of the cells.

This document also discloses a ridge pan to be provided on top of a building. The ridge pan may be used at the top of a traditional building having two sloped roof sides that may comprise the photovoltaic panel disclosed. The ridge pan comprises lateral openings comprising slats and the hot air flowing from the ridges may flow out of the building through the lateral openings provided in the ridge pan at the top of a building.

### SUMMARY

It is preferred to provide more efficient passive cooling for a photovoltaic panel.

A first aspect provides a heat sink panel for receiving thermal energy from a photovoltaic panel. The heat sink panel comprises a shaped metal sheet, wherein at least part of the metal sheet is shaped into substantially parallel gutters. When attached to the photovoltaic panel, the gutters form channels between the heat sink panel and the photovoltaic panel. The gutters range from a proximal gutter end to a distal gutter end and the distal end and the proximal end comprise openings enabling an air flow through the gutters. Sides of the gutters comprise partial cut out areas formed by a line cut having a first cut end and a second cut end defining a folding line from the first cut end to the second cut end.

Whereas known heat sinks comprise protrusions like parallel oriented fins, they do are not arranged to provide more or less closed channels at the back of the photovoltaic panel to enable a stream of air to flow through the channel. Channels do not have to be fully closed, smaller openings may be provided in the channels.

The mere availability of a channel and wind already provides a flow of air through the channel. Alternatively or additionally, the panel may be provided under angle relative to the earth surface, i.e. in a configuration wherein one end of the channel is lower than another, opposite end. By virtue of heating of the air in the channel, air will flow from the lower end to the higher end due to unforced natural convection. The channel may provide functionality as a kind of chimney. Such flow of air in a closed spaced can provide more efficient cooling as compared to a heat sink having open channels between fins.

By means of the cut-out openings, openings in walls of the channel may be provided by folding the cut out areas over the folding lines. In that way, areas of the flaps may be opened by providing the flaps under an angle with the wall of the channel, by folding the flaps over the folding line. Tests have shown this provides more efficient cooling. In such embodiment, more exposure is provided to cooler air surrounding the heatsink by the turbulence generated by the flow around the flaps increasing mixing of hot air with cooler air.

In another embodiment, the folding line is substantially perpendicular to the length of the gutters. This means that in such embodiments, the flaps provide an opening in a direction pointing towards and end of the gutter. Tests have shown this provides more efficient cooling.

In a further embodiment, the cut out areas are grouped in a first group in which the folding line is located at a proximal side of the gutter and the cut is located at a distal side; and a second group in which the folding line is located at a distal side of the gutter and the cut is located at a proximal side. Tests have shown this provides more efficient cooling.

In yet another embodiment, the sheet comprises substantially flat areas between the gutters, the flat areas being located in one and the same imaginary plane. And advantage of this embodiment is that a surface is provided for connecting or attaching the heat sink to a photovoltaic panel and to the back side in particular.

In yet a further embodiment, the sheet has a thickness of 0.5 millimetres or less, 0.4millimetres or less, 0.3 millimetres or less, 0.2 millimetres or less and preferably 0.1 millimetres or less. With such thickness, even at 0.1 millimetres, the heat sink panel provides enough stability and rigidity to known photovoltaic panels that a frame around the panel may be omitted. This allows for weight and cost reduction of a photovoltaic panel.

The various embodiments provide, as sole embodiment and in particular combined, an optimum for providing cooling of the panel, rigidity to the photovoltaic panel, material use and cost price.

A second aspect provides a photovoltaic panel comprising a photovoltaic laminate for converting at least part of received solar radiation to electrical energy and the heat sink according to any of the preceding claims.

### BRIEF DESCRIPTION OF THE DRAWINGS

The various aspects and embodiments thereof will now be discussed in further details in conjunction with drawings. In the drawings,
Figure 1: shows a heat sink panel having triangular gutters;
Figure 2 A: shows a heat sink panel having rectangular gutters;
Figure 2 B: shows a heat sink having half-round gutters
Figure 2 C: shows a heat sink having trapezium shaped gutters
Figure 3: shows a heat sink panel having cut-out flaps in walls of a gutter folded perpendicularly to the gutter length;
Figure 4: shows a heat sink panel having cut-out flaps in walls of a gutter folded parallel to the gutter length;
Figure 5: shows a heat sink panel having cut-out flaps having two cut lines;
Figure 6: shows a photovoltaic panel with a heat sink panel; and
Figure 7: shows a heat sink panel comprising two sub-sinks skewed relative to one another.
Figure 8 A: shows a first solar power production setup; and
Figure 8 B: shows a second solar power production setup.

### DETAILED DESCRIPTION

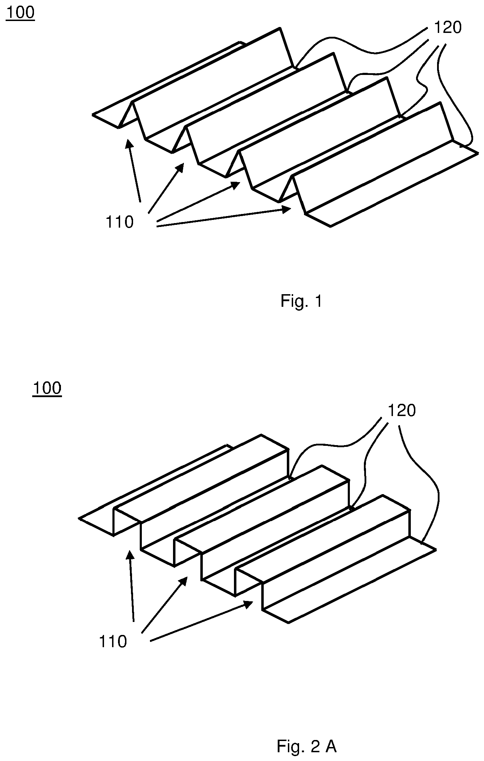

Figure 1 shows a heatsink panel 100. The heatsink panel 100 is arranged to be attached to an object having a substantially flat area for receiving thermal energy from the object. The heatsink panel comprises gutters 110 that are provided substantially parallel to one another. Between the gutters 110, connecting lanes 120 are provided. In this embodiment, the connecting lanes 120 have substantially the same width as the gutters 110, but other dimensions, wider or narrower, may be envisaged as well.

The connecting lanes, as flat areas provided in one and the same imaginary plane, provide a connecting area for connecting the heat sink panel 100 to the object. In one embodiment, the connecting lanes may be omitted and the heat sink panel 100 is connected to the object via the upper ridges of the gutters 110.

The heatsink panel 100 may be manufactured by means of rolling a flat metal sheet, for example comprising aluminium or steel or another iron holding compound, in a desired shape. The starting material may be a flat metal sheet, or, alternatively, a pre-shaped metal sheet. Such preshaping may comprise embossing the sheet with a regular, semi-regular or random three-dimensional pattern of which the differences in height due to roughness is negligible relative to the depth of the gutters. Such patterns may be rounded or dome shaped, pyramid shaped, square, triangular or rectangular or otherwise shaped. The embossing is preferably maintained in the rolling process.

The gutters 110 have a triangular cross-section and are shaped by substantially parallel folds provided in the sheet material comprised by the heatsink panel 100. The top angle of the triangular shape may be between 25° and 60° and preferably between 35° and 45°, where a value of 40° is preferred. In another embodiment, the top angle of the triangular shape is between 20° and 40°, more preferably between 25° and 25°, even more preferably between 30° and 28° and most preferably at 29°.

The depth of the gutter 110 is preferably 4 centimetres, with a top angle of 40° this results in a width of the gutter of approximately 3 centimetres. With a top angle of 29°, this results in a gutter width, at the top of the gutter, of approximately 2 centimetres and more in particular between 21 and 22 millimetres and most particularly 21.6 millimetres. The connecting lane preferably has a width between 22 millimetres and 26 millimetres and most preferably is 24 millimetres.

The sheet material comprised by the heatsink panel 100 as shown by Figure 1 preferably comprises thermally conductive material and a metal in particular. Aluminium is highly preferred, due to its cost and its resistance against corrosion - once a protective corroded layer is provided at the outside. The aluminium sheet material preferably has a thickness of less than 0,5 millimetres, more preferably less than 0.2 millimetres and most preferably equal to or less than 0.1 millimetres. The outer surface of the heatsink panel may be smoot or, alternatively, roughed. The roughening may be provided by brushing aluminium - or another metal - by means of a hard brush or equivalent tool, by pitting, by grinding, any patterning, for example in a three-dimensional diamond shape or another three-dimensional shape, or a combination thereof.

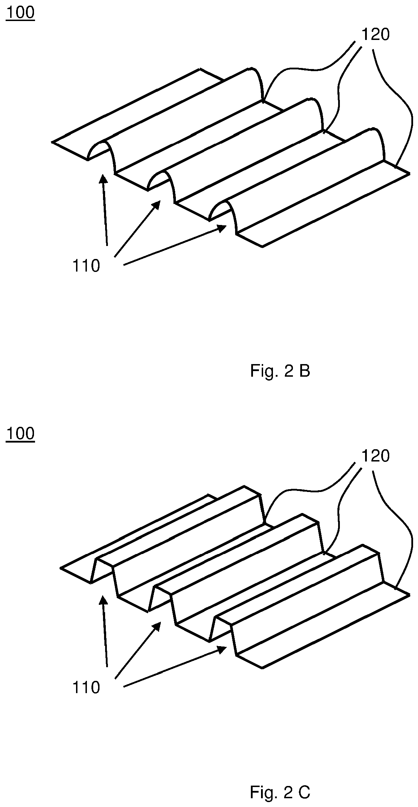

Whereas a triangular cross-section of the gutters 110 as shown by Figure 1 is preferred, differently shaped gutters may be envisaged as well. Figure 2 A shows another heatsink panel 100 having gutters 110 with a substantially rectangular, square cross-section that are connected via connecting lanes 120. Differently shaped gutters, having curved shapes, for example trapezoid as depicted by Figure 2 B, (semi-)circular as depicted by Figure 2 C, elliptical or sinusoidal, may be envisaged as well.

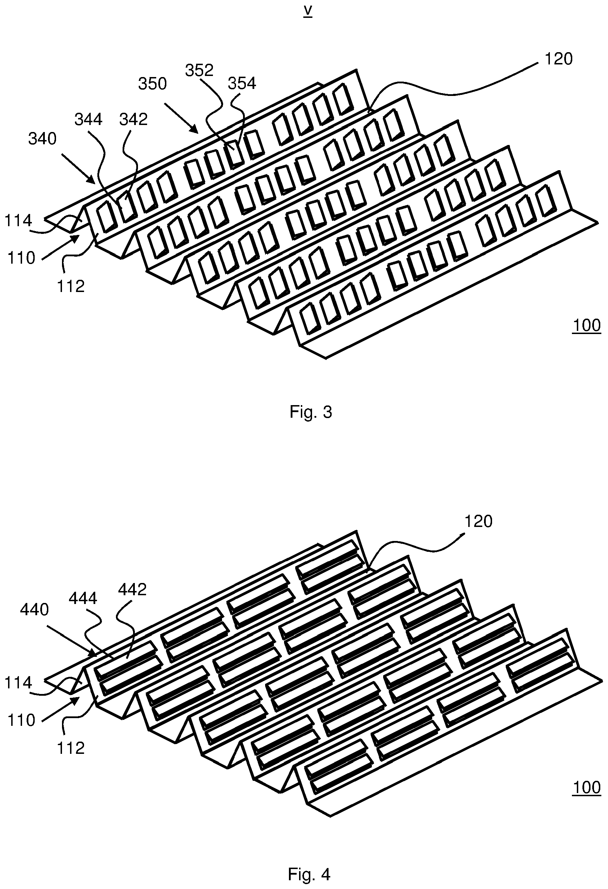

Figure 3 shows a further embodiment of the heat sink panel 110. In a first wall 112 of the gutter 110, a first group 430 of first cut-out flaps 342 is provided. Next to the first group 430, a second group 350 of second cut-out flaps 352 is provided. In this embodiment, each group comprises four cut-out flaps, but other numbers may be envisaged as well, like two, three, five, six, seven or eight.

The set of two groups may be repeated along the length of the gutter 110, dependent on the size of the cut-out flaps and the length of the gutter 110. Flaps having a width of 1 centimetre, spaced apart 1 centimetre and a height of approximately 3 centimetres are preferred. More preferably, the flaps are 10 millimetres wide, 8 millimetres spaced apart and 28 millimetres high. The distance between the groups may be about 2 centimetres and is preferably 18 millimetres.

In the first group 340 of first cut-out flaps 342, the cut-out flaps 342 formed by adjacent three cuts forming a rectangular shape. Of the rectangular shape, at one side no cut along the full length of the rectangular flap is provided. In this way, the cut-out flap 342 is connected to the first wall 112. As shown by Figure 3, the first cut-out flap 342 is folded outwardly over the first not fully cut side 344 of the rectangle. The angle of the fold may be between 30° and 60°, preferably between 40° and 50° and most preferred at 45°.

With the first group 430, the first not fully cut side 344 is provided at a proximal end of the first cut-out flap and with the second group 350, a second not fully cut side 354 of the second flap 342 is provided at a distal end of the second cut-out flap 352. Also the second cut-out flap 352 is folded outwardly.

The first not fully cut side 344 and the second not fully cut side 354 are provided substantially perpendicular to the length of the gutter 110. Substantially perpendicular is in this embodiment to be understood as strictly perpendicular with a deviation of at most 5°, preferably not more than 4°. Alternatively, the cut-out flap is provided under an angle of more than 5°, preferably not more than 10 ° deviating form the normal of the length of the gutter 110. In another embodiment, the not fully cut sides of the cut-out flaps are only provided at the distal side or at the proximal side of the cut-out flaps. Preferably, cut-out flaps are provided at a second wall 114 of the gutter 110 as well, preferably opposite of the cut-out flaps at the first wall 112 of the gutter 110. The cut-outs flaps in the second wall 114 preferably have their not fully cut sides located at the same side as the not fully cut sides at the first wall 112.

Figure 4 shows yet another embodiment of the heat sink panel 100. The gutters 110 have a substantially triangular cross-section. In the first wall 112 and preferably also in the second wall 114, horizontally oriented cut-out flaps 442 are provided. Preferably, one, two or three cut-out flaps are provided above one another in the first wall 112, in a first group 440. The cut-out flap 442 as shown by Figure 4 have a not fully cut side 444 provided at a proximal side relative to the bottom of the gutter 110. The cut-out flap 442 is folded outwardly over the not fully cut side 444. In another embodiment, the not fully cut side 444 is provided at a distal side relative to the bottom of the gutter 110, at the side of the connecting lane 120. Figure 4 shows multiple groups of horizontally oriented cut-out flaps along the length of the gutter 110.

In the embodiments discussed above, the cut-out flaps have a substantially rectangular shape. Whereas this is preferred, the cut-out flaps may also have a square, circular, elliptical, trapezoid, triangular or otherwise polygon or curved shape. For all these shapes, it is preferred the flap is at least at some point connected to the wall of the gutter 110 and folded outward from the gutter over the connecting part.

In the embodiments shown, the cut-out flaps are folded over the line from the first end of the cut to the second end of the cut, with a straight fold over a straight line. In another embodiment, folding of the flaps is not constituted by folding them over a straight and sharp line, but by bending them over a line from the first end of the cut to the second end of the cut.

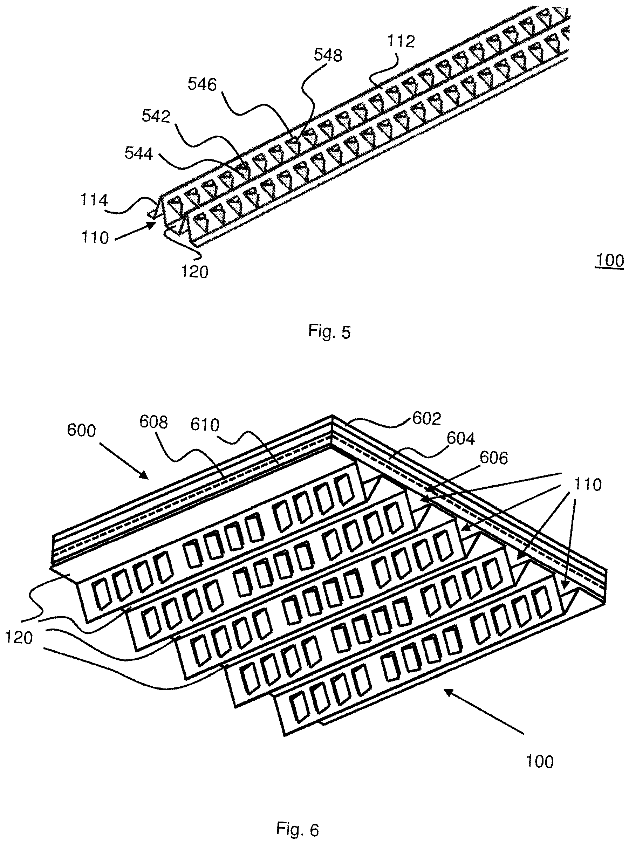

As an option to this embodiment, the cut defining a, for example, a substantially rectangularly defined cut-out flap, does not have to cover more than half the cut-out flap. In one particular embodiment as depicted by Figure 5, a rectangular flap is defined by a cut covering two sides of a flap 542. and the cut-out flap is folded, for example over a bend or folding line 544 along a diagonal of the flap, from the first end of the cut to the second end of the cut. This results in a triangular part of the cut-out flap being folded outwardly, or, alternatively, inwardly. The folding line preferably has an angle between 35° and 75° relative to the bottom line of the gutter - or top line of the triangle -, more preferably between 45° and 65°, even more preferably between 50° and 60° and most preferably of about 55°.

The flap 542 is, after cutting of the cut line, preferably folded out at an angle between 35° and 55°, more preferably between 40° and 50° and most preferably at 45°. In one embodiment, the angles of the flaps 542 relative to the walls of the gutter 110 vary over the heatsink panel 100. In the centre of the panel, the angle may be larger than near the edges of the heatsink panel 100. This means that in the centre of the heatsink panel 100, the openings at the flaps 542 are larger or more open than near the edges. If the heatsink panel 100 is in use, with a photovoltaic panel mounted on it, is placed under an angle relative to the earth surface, the angles of the flaps 542 may be larger at the upper edge of the panel than at the lower edge. This embodiment may also be combined with embodiments of heatsinks disclosed above and below.

In this embodiment, a first cut line 546 is preferably and optionally provided near the top of the triangle and parallel to the pinnacle line of the triangle - or the bottom of the gutter - and a second cut line 548 perpendicular to the first cut line, towards the connecting lane 120. This means that the first cut line 546 and the second cut line 548 are substantially rectangular relative to one another.

In other embodiments, the first cut line and the second cut line are not exactly perpendicular to one another, but substantially perpendicular as under an angle of 5% more or less or even 10% more or less than ninety degrees to one another. Furthermore, in other embodiments that may be combined with variations in the angles between cut lines, the first cut line 546 may be substantially parallel to the top of the triangle or not. Likewise, the second cut line 548 may be substantially perpendicular to the top line of the triangle - i.e. the bottom of the gutter - or not. In this way, the angular orientation of the flap 542 may be varied on the side of the gutter 110.

In yet another embodiment, the flaps 542 are not defined by the first cut line 546 and the second cut line 548 as substantially straight cut lines that join at an angle, but by a cut of which a first end is at angle to an opposite second end of the cut. Preferably, such angle is preferably substantially ninety degrees. The cut may follow a particular trajectory comprising at least one of straight, curved or otherwise shaped sections that are connected in a smooth way or are joined at acute or obtuse angles.

In another embodiment, that may also comprise characteristics of the embodiment described in other paragraphs above discussing Figure 5, the first cut end and the second cut end define a line that is under an angle with the bottom line of the gutter 110. The angle of this line is preferably between 35° and 75°, more preferably between 45° and 65°, even more preferably between 50° and 60° and most preferably of about 55°. In another embodiment, an angle of 45° of 50° plus or minus 5° is preferred.

An advantage of folding the flaps by bending, rather than folding them over a straight line, is that the heat sink panel 100 may be stacked in a more convenient way, in particular with the specific embodiment discussed directly above.

Furthermore, it is preferred the connection between the cut-out flaps and the wall is per group of cut-out flaps provided one the same side of the cut-out flaps. The group can comprise all cut-out flaps on a wall or a specific number of cut-out flaps, as discussed above.

Figure 6 shows the heat sink panel 100 connected to a photovoltaic panel 600. The photovoltaic panel 600 comprises an active layer 604, comprising semiconductor material of a first conductivity type and semiconductor material of a second conductivity type such that a junction between both types of materials is provided over a large area of the active layer 604 for converting received solar radiation to electricity. Op top of the active layer 602, a protective and for at least some solar radiation substantially transparent protective layer 602 is provided. The protective layer 602 may comprise sub-layers, for example for providing rigidity, for reducing reflection, for other purposes, or for a combination of these purposes.

Below the active layer 604, a support layer 606 is provided. The support layer 606 is provided for the purpose of providing some rigidity to the photovoltaic panel 600, for protecting the rear side or the bottom side of the active layer 604, for conducting thermal energy from the active layer 604 to the heat sink 100, other purposes or a combination of these purposes.

The support layer may comprise a polymer and a polyolefin in particular, as commonly used for photovoltaic panels. In another embodiment, the support layer 606 comprises a thermally highly conductive material and preferably a metal layer in particular, for example comprising aluminium. An issue with metal is that it may not provide sufficient electrical isolation of the active layer 604. Therefore, the support layer 606 may comprise a electrically isolating sub-layer 608 and a thermally highly conductive sub-layer 610. The electrically isolating sub-layer 608 preferably has suitable thermally conductive properties as well, though electrically isolating properties are more important in order to isolate the active layer 604 from the heat sink 100 and the highly conductive sub-layer 610.

With the highly conductive sub-layer 610 provided at the back side of the photovoltaic panel 600, channels are formed by the gutters 110 in the heat sink 100 and the highly conductive sub-layer 610 that have highly conductive material at all sides. This allows for improved heat removal - removal of thermal energy - compared to embodiments in which the photovoltaic panel 600 has a conventional polymer support layer 606.

The heat sink panel 100 is connected to the outer side of the support layer 606. The connection may be provided by means of an adhesive, screws, rivets, nails, bolts, snap-fit connections, other, or a combination thereof.

The heat sink panel 100 is preferably connected to the photovoltaic panel 600 via a thermally conductive connection. This connection may be provided by providing a direct contact between the heat sink panel 100 and the photovoltaic panel 600 or by providing a conductive material in between. In the latter case, such material may be a heat conducting adhesive or other preferably fluid material that may harden out and/or cure after application.

Figure 6 shows the heat sink 100 being provided at substantially the full area of the backside of the photovoltaic panel 600. In another embodiment, the heat sink 100 is provided at only a part of the backside of the photovoltaic panel. In such embodiment, more than one heat sinks 100 may be provided, a complementary areas of the backside of the support layer 606 - so at the backside of the photovoltaic panel 600.

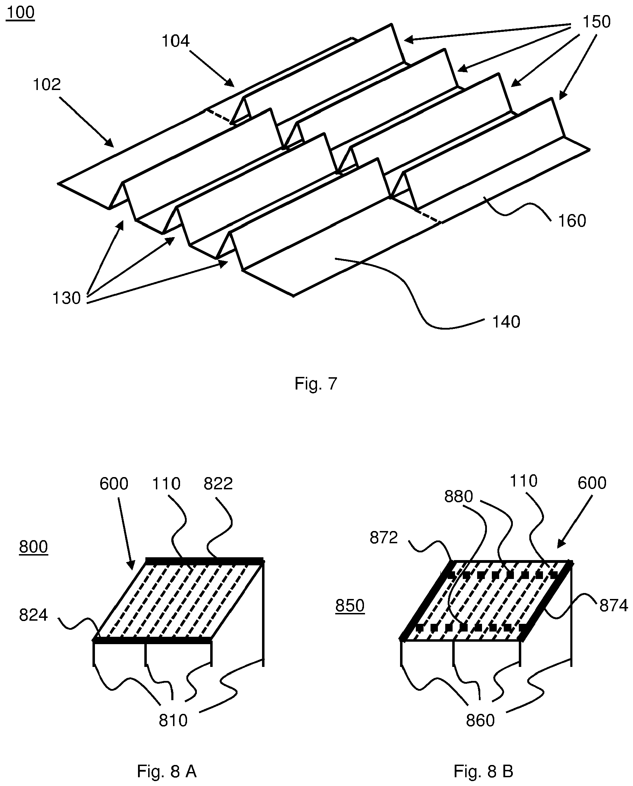

In the description above and the Figures discussed so far, the heat sink 100 has been discussed as comprising the gutter 110 that range from a first side of the heat sink 100 to a second, opposite side of the heat sink 100. And in all embodiments discussed and shown thus far, the gutters 110 have been shown to run substantially perpendicular to the sides at which they debouch. In another embodiment, the gutters may be placed under an angle relative to the sides at which they debouch. Furthermore, alternatively from running from end to end, gutters may be provided running over only a part of the heat sink 100 or only part of the photovoltaic panel 600. Figure 7 shows an embodiment in which the gutters do not run from end to end.

Figure 7 shows a compound heatsink 100 comprising a first sub-sink 102 and a second sub-sink 104. The first sub-sink 102 comprises first gutters 130 and the second sub-sink 104 comprises second gutters 150. Between the first gutters 130, first connecting lanes 140 are provided and between the second gutters 150, second connecting lanes 160 are provided. In this embodiment, the lanes are as wide as the gutters, for both sub-sinks. The first sub-sink 102 is skewed by half a pitch relative to the second sub-sink 104 such that a first gutter is provided in extension of a second connecting lane.

In another embodiment, a compound heatsink is envisaged in which the gutters of the individual heatsinks are provided substantially in extension of one another.

Standard photovoltaic panels have, at the filing date of this application, dimensions of 1 metre by 1.6 metre. The gutters may be provided over either the length or the width of the photovoltaic panel 600 (Figure 6), depending on the orientation of the photovoltaic panel 600 during use. As the channels provided between the gutters 110 and the support layer 606 are intended to provide a chimney effect for channelling air for removing thermal energy, it is important the channels are in use oriented from a lower edge of the panel to a higher edge of the panel, rather than from edges of the panel having substantially the same height.

Figure 8 A shows a first solar power production setup 800. The first solar power production setup 800 comprises a first support frame comprising an upper support beam 822 and a bottom support beam 824 for supporting the photovoltaic panel 600 with the heatsink 100. The support beams are supported by vertical support poles 810. The photovoltaic panel 600 is provided on the support beams such that the gutters 110 run from high to low, perpendicularly to the support beams.

Figure 8 B shows a second solar power production setup 850. The second solar power production setup 850 comprises a second support frame comprising a left support beam 872 and a right support beam 874 for supporting the photovoltaic panel 600 with the heatsink 100. The support beams are supported by vertical support poles 860. The photovoltaic panel 600 is provided on the support beams such that the gutters 110 run from high to low, perpendicularly to the support beams.

With the first solar power production setup 800, the support beams provide additional support to the photovoltaic panel 600 perpendicular to support provided by the gutters 110. This means that, in operation, rigidity is provided in two substantially perpendicular directions.

With the second solar power production setup 850, the support beams provide additional support to the photovoltaic panel 600 parallel to support provided by the gutters 110. This means that, in operation, rigidity is provided in two substantially parallel directions - and limited support is provided over a direction perpendicular to the gutters 110. Therefore, the system of the photovoltaic panel 600 and the heat sink 100 is provided with panel support beams 880 that run perpendicular to the length of the gutters 110. The panel support beams 880 do not interrupt the channels provided by the gutters 110 and the back of the photovoltaic panel. The panel support beams 880 may be provided with indentations in which the gutters 110 fit. Alternatively or additionally, the panel support beams are provided on top of the gutters 110 such that they extend from the heat sink beyond the extremities of the gutters 110.

An advantage of a compound heatsink is that this allows the heatsink to be connected to the photovoltaic process by means of a lamination process. Optionally, the photovoltaic laminate, including the heatsink, may be manufactured in one single process step.

As the thermal extension coefficients of aluminium - or another suitable material - are significantly different, connecting one single heatsink with substantially the same size as the photovoltaic panel by means of a lamination process using heat will result in a bent end product. By using multiple smaller heatsinks as one large compound heatsink having substantially the same size as the photovoltaic panel, the impact of this issue is at least reduced. In case one large heatsink is preferred, for example, in view of preferred rigidity of the total product, the heatsink is connected to the photovoltaic in an adhesion process not employing heat or employing reduced heat compared to lamination. In one embodiment, an adhesive, like glue, another adhesive or a combination thereof, is used. The adhesive preferably conducts thermal energy in an efficient way from the photovoltaic panel to the heatsink.

Other embodiments may be envisaged in which the gutters and the connecting lanes do not have the same width. Yet, it is preferred the pitch - the total width of one gutter and one connecting lane - have substantially the same width.

In the description above, it will be understood that when an element such as layer, region or substrate is referred to as being "on" or "onto" another element, the element is either directly on the other element, or intervening elements may also be present. Also, it will be understood that the values given in the description above, are given by way of example and that other values may be possible and/or may be strived for.

Furthermore, the invention may also be embodied with less components than provided in the embodiments described here, wherein one component carries out multiple functions. Just as well may the invention be embodied using more elements than depicted in the Figures, wherein functions carried out by one component in the embodiment provided are distributed over multiple components.

It is to be noted that the figures are only schematic representations of embodiments of the invention that are given by way of non-limiting examples. For the purpose of clarity and a concise description, features are described herein as part of the same or separate embodiments, however, it will be appreciated that the scope of the invention may include embodiments having combinations of all or some of the features described. The word 'comprising' does not exclude the presence of other features or steps than those listed in a claim. Furthermore, the words 'a' and 'an' shall not be construed as limited to 'only one', but instead are used to mean 'at least one', and do not exclude a plurality.

A person skilled in the art will readily appreciate that various parameters and values thereof disclosed in the description may be modified and that various embodiments disclosed and/or claimed may be combined without departing from the scope of the invention.

It is stipulated that the reference signs in the claims do not limit the scope of the claims, but are merely inserted to enhance the legibility of the claims.

## Claims

1. Heat sink panel for receiving thermal energy from a photovoltaic panel, the heat sink panel comprising a shaped metal sheet, wherein at least part of the metal sheet is shaped into substantially parallel gutters for forming, when attached to the photovoltaic panel, channels between the heat sink panel and the photovoltaic panel, wherein the gutters range from a proximal gutter end to a distal gutter end and the distal end and the proximal end comprise openings enabling an air flow through the channels; **characterised in that** sides of the gutters comprise partial cut out areas formed by a line cut having a first cut end and a second cut end defining a folding line from the first cut end to the second cut end.

2. Heat sink according to claim 1, wherein the folding line is provided under an angle relative to the gutters.

3. Heat sink according to any of the preceding claims, wherein the partial cut out areas have a substantially rectangular or triangular shape.

4. Heat sink according to claim 1 or claim 3 to the extent dependent on claim 1, wherein the folding line is substantially perpendicular to the gutters.

5. Heat sink according to claim 4, wherein the partial cut out areas are grouped in:
- a first group in which the folding line is located at a proximal side of the gutter and the cut is located at a distal side; and
- a second group in which the folding line is located at a distal side of the gutter and the cut is located at a proximal side.

6. Heat sink according to claim 5, wherein the first group and the second group are intermittently distributed from the proximal side of the sheet to the distal side of the sheet.

7. Heat sink panel according to any of the preceding claims, wherein the gutters are formed by substantially parallel folds.

8. Heat sink panel according to any of the preceding claims, wherein the gutters have sloped sides.

9. Heat sink according to any of the claims 1, 3 and 5 through 7 to the extent dependent on claim 1 or 3, wherein the folding line is substantially parallel to the gutters.

10. Heat sink according to any of the preceding claims, wherein the partial cut out areas are arranged to be folded outward from or inward into the gutter for providing an opening.

11. Heat sink according to any of the preceding claims, wherein the sheet comprises substantially flat areas between the gutters, the flat areas being located in an imaginary plane.

12. Heat sink according to any of the preceding claims, wherein the gutters are triangularly shaped.

13. Heat sink according to any of the preceding claims, wherein the metal is aluminium.

14. Heat sink according to any of the preceding claims, wherein the sheet has a thickness of 0.5 millimetres or less, 0.4 millimetres or less, 0.3 millimetres or less, 0.2 millimetres or less and preferably 0.1 millimetres or less or a thickness of 0.3 millimetres plus or minus 0.1 millimetres.

15. Photovoltaic panel comprising:
- a photovoltaic laminate comprising an active layer for converting at least part of received solar radiation to electrical energy and a support layer provided for supporting the active layer; and
- the heat sink according to any of the preceding claims provided on the support layer.

16. Photovoltaic panel according to claim 15, wherein the support layer comprises a thermally highly conductive sub-layer in thermally conductive contact with the heat sink.

## Patentansprüche

1. Kühlkörperplatte zum Empfangen von Wärmeenergie von einer Photovoltaikplatte, wobei die Kühlkörperplatte ein geformtes Metallblech umfasst, wobei wenigstens ein Teil des Metallblechs zu im Wesentlichen parallelen Rinnen geformt ist, um beim Anbringen an der Photovoltaikplatte Kanäle zwischen der Kühlkörperplatte und Photovoltaikplatte zu bilden, wobei die Rinnen von einem proximalen Rinnenende zu einem distalen Rinnenende reichen und das distale Ende und das proximale Ende Öffnungen umfassen, die einen Luftstrom durch die Kanäle ermöglichen;
**dadurch gekennzeichnet, dass**
Seiten der Rinnen teilweise ausgeschnittene Bereiche umfassen, die durch einen Linienschnitt mit einem ersten Schnittende und einem zweiten Schnittende gebildet sind, die eine Faltlinie vom ersten Schnittende zum zweiten Schnittende definieren.

2. Kühlkörper nach Anspruch 1, wobei die Faltlinie unter einem Winkel relativ zu den Rinnen vorgesehen ist.

3. Kühlkörper nach einem der vorhergehenden Ansprüche, wobei die teilweise ausgeschnittenen Bereiche eine im Wesentlichen rechteckige oder dreieckige Form haben.

4. Kühlkörper nach Anspruch 1 oder Anspruch 3 in dem von Anspruch 1 abhängigen Ausmaß, wobei die Faltlinie im Wesentlichen senkrecht zu den Rinnen verläuft.

5. Kühlkörper nach Anspruch 4, wobei die teilweise ausgeschnittenen Bereiche gruppiert sind in:
- eine erste Gruppe, in der sich die Faltlinie an einer proximalen Seite der Rinne und der Schnitt an einer distalen Seite befindet; und
- eine zweite Gruppe, bei der sich die Faltlinie an einer distalen Seite der Rinne und der Schnitt an einer proximalen Seite befindet.

6. Kühlkörper nach Anspruch 5, wobei die erste Gruppe und die zweite Gruppe intermittierend von der proximalen Seite des Blechs zur distalen Seite des Blechs verteilt sind.

7. Kühlkörperplatte nach einem der vorhergehenden Ansprüche, wobei die Rinnen durch im Wesentlichen parallele Falten gebildet sind.

8. Kühlkörperplatte nach einem der vorhergehenden Ansprüche, wobei die Rinnen geneigte Seiten haben.

9. Kühlkörper nach einem der Ansprüche 1, 3 und 5 bis 7 in dem von Anspruch 1 oder 3 abhängigen Ausmaß, wobei die Faltlinie im Wesentlichen parallel zu den Rinnen verläuft.

10. Kühlkörper nach einem der vorhergehenden Ansprüche, wobei die teilweise ausgeschnittenen Bereiche so angeordnet sind, dass sie zur Bereitstellung einer Öffnung nach außen oder innen in die Rinne gefaltet werden.

11. Kühlkörper nach einem der vorhergehenden Ansprüche, wobei das Blech im Wesentlichen flache Bereiche zwischen den Rinnen umfasst, wobei sich die flachen Bereiche in einer imaginären Ebene befinden.

12. Kühlkörper nach einem der vorhergehenden Ansprüche, wobei die Rinnen dreieckig geformt sind.

13. Kühlkörper nach einem der vorhergehenden Ansprüche, wobei das Metall Aluminium ist.

14. Kühlkörper nach einem der vorhergehenden Ansprüche, wobei das Blech eine Dicke von 0,5 mm oder weniger, 0,4 mm oder weniger, 0,3 mm oder weniger, 0,2 mm oder weniger und vorzugsweise 0,1 mm oder weniger, oder eine Dicke von 0,3 mm aufweist plus oder minus 0,1 mm.

15. Photovoltaikmodul umfassend:
- ein Photovoltaik-Laminat, umfassend eine aktive Schicht zum Umwandeln wenigstens eines Teils der empfangenen Sonnenstrahlung in elektrische Energie und eine Trägerschicht, die zum Tragen der aktiven Schicht vorgesehen ist; und
- den Kühlkörper nach einem der vorhergehenden Ansprüche, der auf der Trägerschicht vorgesehen sind.

16. Photovoltaikplatte nach Anspruch 15, wobei die Trägerschicht eine wärmeleitende Unterschicht in thermisch leitendem Kontakt mit dem Kühlkörper umfasst.

## Revendications

1. Panneau dissipateur de chaleur pour recevoir de l'énergie thermique d'un panneau photovoltaïque, le panneau dissipateur de chaleur comprenant une tôle de métal façonnée, dans lequel au moins une partie de la tôle de métal est façonnée en des gouttières substantiellement parallèles pour former, lorsqu'elle est fixée au panneau photovoltaïque, des canaux entre le panneau dissipateur de chaleur et le panneau photovoltaïque, dans lequel les gouttières sont comprises entre une extrémité de gouttière proximale et une extrémité de gouttière distale et l'extrémité distale et l'extrémité proximale comprennent des ouvertures permettant un écoulement d'air à travers les canaux ; **caractérisé en ce que** des côtés des gouttières comprennent des zones de découpes partielles formées par une découpe de ligne ayant une première extrémité de découpe et une seconde extrémité de découpe définissant une ligne de pliage de la première extrémité de découpe à la seconde extrémité de découpe.

2. Dissipateur de chaleur selon la revendication 1, dans lequel la ligne de pliage est fournie sous un angle par rapport aux gouttières.

3. Dissipateur de chaleur selon l'une quelconque des revendications précédentes, dans lequel les surfaces de découpes partielles présentent une forme substantiellement rectangulaire ou triangulaire.

4. Dissipateur de chaleur selon la revendication 1 ou revendication 3 dans la mesure où elle dépend de la revendication 1, dans lequel la ligne de pliage est substantiellement perpendiculaire aux gouttières.

5. Dissipateur de chaleur selon la revendication 4, dans lequel les surfaces de découpes partielles sont groupées en :
un premier groupe dans lequel la ligne de pliage est disposée sur un côté proximal de la gouttière et la découpe est disposée sur un côté distal ; et
un second groupe dans lequel la ligne de pliage est disposée sur un côté distal de la gouttière et la découpe est disposée sur un côté proximal.

6. Dissipateur de chaleur selon la revendication 5, dans lequel le premier groupe et le second groupe sont distribués de manière intermittente à partir du côté proximal de la tôle jusqu'au côté distal de la tôle.

7. Panneau dissipateur de chaleur selon l'une quelconque des revendications précédentes, dans lequel les gouttières sont formées par des pliages substantiellement parallèles.

8. Panneau dissipateur de chaleur selon l'une quelconque des revendications précédentes, dans lequel les gouttières présentent des côtés inclinés.

9. Dissipateur de chaleur selon l'une quelconque des revendications 1, 3 et 5 à 7, dans la mesure où elle dépend de la revendication 1 ou 3, dans lequel la ligne de pliage est substantiellement parallèle aux gouttières.

10. Dissipateur de chaleur selon l'une quelconque des revendications précédentes, dans lequel les surfaces de découpes partielles sont disposées pour être pliées à l'extérieur de ou à l'intérieur dans la gouttière pour fournir une ouverture.

11. Dissipateur de chaleur selon l'une quelconque des revendications précédentes, dans lequel la tôle comprend des surfaces substantiellement planes entre les gouttières, les surfaces planes étant disposées dans un plan imaginaire.

12. Dissipateur de chaleur selon l'une quelconque des revendications précédentes, dans lequel les gouttières sont façonnées en triangle.

13. Dissipateur de chaleur selon l'une quelconque des revendications précédentes, dans lequel le métal est l'aluminium.

14. Dissipateur de chaleur selon l'une quelconque des revendications précédentes, dans lequel la tôle présente une épaisseur de 0,5 millimètre ou inférieure, 0,4 millimètre ou inférieure, 0,3 millimètre ou inférieure, 0,2 millimètre ou inférieure et de préférence 0,1 millimètre ou inférieure ou une épaisseur de 0,3 millimètre plus ou moins 0,1 millimètre.

15. Panneau photovoltaïque comprenant :
- un stratifié photovoltaïque comprenant une couche active pour convertir au moins une partie de rayonnement solaire reçu en énergie électrique et une couche de support fournie pour supporter la couche active ; et
- le dissipateur de chaleur selon l'une quelconque des revendications précédentes fourni sur la couche de support.

16. Panneau photovoltaïque selon la revendication 15, dans lequel la couche de support comprend une sous-couche hautement thermiquement conductrice en contact thermiquement conducteur avec le dissipateur de chaleur.
